# EUROPÄISCHE PATENTSCHRIFT

(11) **EP 3 616 972 B1**
(45) Veröffentlichungstag und Bekanntmachung des Hinweises auf die Patenterteilung: **09.02.2022**
(21) Anmeldenummer: 19020127.7
(22) Anmeldetag: 15.03.2019
(51) Int. Cl.: B60L 3/00, B60L 53/22, B60L 53/14, B60L 53/10

(54) **VERFAHREN ZUR STEUERUNG EINER FAHRZEUGEXTERNEN GLEICHSSTROMLADEVORRICHTUNG UND LADEVORRICHTUNG**
CHARGING DEVICE AND METHOD FOR CONTROLLING A DCCHARGING DEVICE OUTSIDE THE VEHICLE
PROCÉDÉ DE COMMANDE D'UN DISPOSITIF DE CHARGE À L'EXTÉRIEUR DU VÉHICULE ET DISPOSITIF DE CHARGE

(30) Priorität: 31.08.2018 DE 102018121320
(43) Veröffentlichungstag der Anmeldung: 04.03.2020
(73) Patentinhaber: Dr. Ing. h.c. F. Porsche AG, 70435 Stuttgart (DE)
(72) Erfinder: Spesser, Daniel, 75428 Illingen (DE); Pfizenmaier, Tim, 71229 Leonberg (DE)

(56) Entgegenhaltungen:
- DE-A1- 19 944 409
- DE-A1-102013 226 023

## Beschreibung

Die Erfindung betrifft ein Verfahren zur Steuerung einer fahrzeugexternen Ladevorrichtung zum Laden eines Fahrzeugs, insbesondere eines Elektro- oder Hybridfahrzeugs. Ferner betrifft die Erfindung eine fahrzeugexterne Ladevorrichtung zum Laden eines derartigen Fahrzeugs.

Bei einem Elektrofahrzeug oder einem Hybridfahrzeug ist üblicherweise vorgesehen, dass ein Energiespeicher, welcher den Elektroantrieb des Fahrzeugs mit elektrischer Energie versorgt, mittels einer Ladevorrichtung geladen werden kann. Ein solcher elektrischer Energiespeicher kann als Akkumulator oder als Batterie, insbesondere als Traktionsbatterie, ausgebildet sein.

Eine Ladevorrichtung der eingangs genannten Art ist aus der DE 10 2010 028 626 A1 bekannt. Diese Ladevorrichtung umfasst ein Wechselstromnetz mit einem Neutralleiter, einem Schutzleiter und wenigstens einem Phasenleiter sowie einen Gleichrichter zur Umwandlung einer Wechselspannung des Wechselspannungsnetzes in eine Gleichspannung. Diese Gleichspannung wird an einem Gleichstrom-Ladeanschluss der Ladevorrichtung bereitgestellt. Um sicherzustellen, dass das Elektrofahrzeug beim Ladevorgang gegen einen Fehlerstrom (Berührungsstrom) gegen Erde geschützt ist, umfasst die Ladevorrichtung eine Differenzstrom-Überwachungseinrichtung, die zur Erkennung einer Gleichstromdifferenz ausgelegt ist. Diese Differenzstrom-Überwachungseinrichtung misst die Ströme am Gleichstrom-Ladeanschluss und löst bei einem Fehlerstrom gegen Erde aus, um die Stromversorgung beim Laden zu unterbrechen. Weiterhin beschreibt die DE 10 2013 226 023 A1 eine Vorrichtung und ein Verfahren zur Kompensation eines Spannungsoffsets in einer Energieversorgungsleitung und die DE 199 44 409 A1 offenbart ein Verfahren zur Auslösung einer Differenzstromschutzeinrichtung sowie eine Differenzstromschutzeinrichtung.

Ferner sind Fahrzeuge mit einem Hochvolt-Bordnetz und einem an das Hochvolt-Bordnetz angeschlossenen elektrischen Energiespeicher bekannt. Derartige Hochvolt-Bordnetze sind üblicherweise als IT-System ausgelegt, d.h., dass keine galvanische Verbindung zwischen aktiven Leitern und geerdeten Teilen vorhanden ist. Das Hochvolt-Bordnetz ist während des Ladevorgangs elektrisch mit dem Gleichstrom-Ladeanschluss der Ladevorrichtung verbunden. Falls der Gleichrichter der Ladevorrichtung keine galvanische Trennung aufweist, wandelt sich das als IT-System ausgelegte Hochvolt-Bordnetz in ein geerdetes TT-System. Dies kann unter anderem zur Folge haben, dass in der Ladevorrichtung und/oder im Hochvolt-Bordnetz angeschlossene Y-Kapazitäten, welche unter anderem durch Entstörkondensatoren verursacht werden, Ableitströme auf dem Schutzleiter hervorrufen. Diese Ströme sind von einer Netzfrequenz, einer Schaltfrequenz und von an dem Hochvolt-Bordnetz angeschlossenen Verbrauchern getrieben, sowie von deren Oberwellen. Diese Ableitströme können in der Ladevorrichtung die Fehlerstrom- bzw. Differenzstrom-Überwachungseinrichtung auslösen, was zu einem ungewollten Abbruch des Ladevorgangs führen kann.

Es ist die Aufgabe der vorliegenden Erfindung, die Nachteile des Stands der Technik zu vermeiden.

Die Aufgabe wird durch das Verfahren nach Patentanspruch 1 gelöst.

Erfindungsgemäß wird ein Verfahren zur Steuerung einer fahrzeugexternen Ladevorrichtung zum Laden eines Fahrzeugs, insbesondere eines Elektro- oder Hybridfahrzeugs, vorgeschlagen, wobei die Ladevorrichtung ein Wechselstromnetz mit einem Neutralleiter, einem Schutzleiter und wenigstens einem Phasenleiter, eine Schutz- und Überwachungseinrichtung sowie einen Gleichstrom-Ladeanschluss aufweist, wobei das Fahrzeug ein Hochvolt-Bordnetz und einen an das Hochvolt-Bordnetz angeschlossenen elektrischen Energiespeicher umfasst, wobei das Verfahren folgende Verfahrensschritte umfasst:
- elektrisches Verbinden des Hochvolt-Bordnetzes mit dem Gleichstrom-Ladeanschluss der Ladevorrichtung,
- Erfassen eines Schutzleitwiderstands zwischen dem Neutralleiter und dem Schutzleiter durch Einspeisen eines Prüfstroms mittels der Schutz- und Überwachungseinrichtung, wobei eine Frequenz des Prüfstroms entweder außerhalb eines Kompensations-Frequenzbereichs der Schutz- und Überwachungseinrichtung liegt oder innerhalb des Kompensations-Frequenzbereichs liegt und schmalbandig aus dem Kompensations-Frequenzbereich herausgefiltert wird.

Bevorzugt umfasst der Gleichstrom-Ladeanschluss einen Pluspol und einen Minuspol. Der Gleichstrom-Ladeanschluss kann beispielsweise als CCS-Anschluss nach der Norm IEC 62196 Typ 2 oder als CHAdeMO-Anschluss ausgestaltet sein.

Weiterhin umfasst das Verfahren erfindungsgemäß folgende weitere Verfahrensschritte:
- Erfassen eines Ableitstroms im Schutzleiter,
- in einem vorbestimmten Frequenzbereich, Einspeisen eines zu dem Ableitstrom komplementären Kompensationsstroms, vorzugsweise mittels einer Kapazität gekoppelten Stromkompensationseinheit.

In diesem Zusammenhang hat es sich als vorteilhaft erwiesen, wenn der Frequenzbereich zwischen 5 Hz und 300 kHz, vorzugsweise zwischen 25 Hz und 250 kHz, liegt.

Bevorzugt wird der Ableitstrom im Schutzleiter direkt oder indirekt mittels eines Messstromwandlers erfasst.

Gemäß einer vorteilhaften Ausgestaltung erfolgt das Einspeisen des Kompensationsstroms in Echtzeit oder Quasi-Echtzeit. Unter einem Einspeisen des Kompensationsstroms in Echtzeit oder Quasi-Echtzeit wird verstanden, dass das Einspeisen des Kompensationsstroms innerhalb derselben Netzperiode erfolgt, in welcher der Ableitstrom in dem Schutzleiter erfasst wird.

Vorzugsweise umfasst das Verfahren folgende weitere Verfahrensschritte:
- Trennung der elektrischen Verbindung zwischen dem Hochvolt-Bordnetz und dem Gleichstrom-Ladeanschluss, entweder durch Auslösen einer Trennvorrichtung der Schutz- und Überwachungseinrichtung oder durch Einspeisen eines einem Differenzstrom geleichenden Auslösestroms zum Auslösen einer in dem Energieversorgungssystem installierten Schutzeinrichtung.

Die Erfindung betrifft ferner eine Ladevorrichtung gemäß Patentanspruch 6

Bei der Ladevorrichtung können dieselben Vorteile erreicht werden, wie sie bereits im Zusammenhang mit dem erfindungsgemäßen Verfahren beschrieben worden sind.

Gemäß der Erfindung weist die Schutz- und Überwachungseinrichtung einen Messstromwandler auf, der geeignet ist, Ableitstrom im Schutzleiter direkt oder indirekt zu erfassen.

Erfindungsgemäß weist die Schutz- und Überwachungseinrichtung eine Schleifenwiderstandsmesseinrichtung auf, die geeignet ist, einen Schutzleitwiderstand zwischen dem Neutralleiter und dem Schutzleiter zu erfassen.

Vorteilhaft ist es, wenn der Messstromwandler und die Schleifenwiderstandsmesseinrichtung in eine Messstromeinheit integriert sind.

Gemäß einer vorteilhaften Ausgestaltung weist die Ladevorrichtung mehrere parallel geschaltete Gleichrichtermodule auf, sodass eine die Ausgangsleistung der Ladevorrichtung durch die Wahl einer geeigneten Anzahl an Gleichrichtermodulen eingestellt werden kann. Insbesondere kann auf diese Weise eine höhere Leistung beim Laden erreicht werden, als dies mit einem in dem Fahrzeug angeordneten Gelichrichter der Fall wäre.

Bevorzugt sind die Gleichrichtermodule als galvanisch nicht-getrennte Gleichrichtermodule ausgebildet, sodass die Gleichrichtermodule kompakter und leichter ausgebildet sein können.

Weitere Einzelheiten und Vorteile der Erfindung sollen nachfolgend anhand der in den Zeichnungen beschriebenen Ausführungsbeispiele erläutert werden. Hierin zeigt:
- Fig. 1: ein Ausführungsbeispiel einer Ladevorrichtung gemäß der Erfindung in einem schematischen Blockdiagramm; und
- Fig. 2: ein Ausführungsbeispiel einer Schutz- und Überwachungsvorrichtung in einem schematischen Blockdiagram.

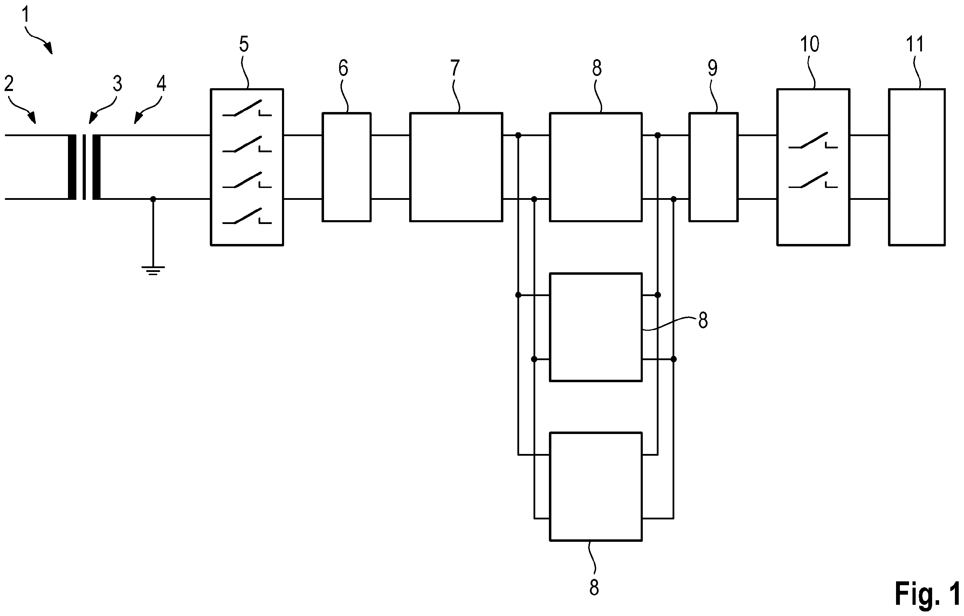

In der Fig. 1 ist eine Ladevorrichtung 1 für ein Fahrzeug gezeigt, welches als Elektro- oder Hybridfahrzeug ausgebildet sein kann. Die Ladevorrichtung 1 umfasst ein als Niederspannungsnetz ausgebildetes Wechselstromnetz 4. Das Wechselstromnetz 4 ist in Fig. 1 nur schematisch dargestellt und umfasst einen Neutralleiter, einen Schutzleiter und mehrere Phasenleiter. Gemäß dem Ausführungsbeispiel ist das Wechselstromnetz 4 über einen Transformator 3 mit einem weiteren Wechselspannungsnetz 2, hier einem Mittelspannungsnetz, gekoppelt.

Die Ladevorrichtung 1 umfasst ferner ein Eingangsfilter 6, welches bevorzugt als EMV-Filter ausgestaltet ist. Zwischen dem Transformator 3 und dem Eingangsfilter 6 ist eine Schaltvorrichtung 5 angeordnet, über welche das Eingangsfilter 6 von dem Transformator 3 galvanisch getrennt werden kann. Die Schaltvorrichtung 5 kann Teil einer Fehterstrom-Schutzeinrichtung (RCD) sein.

Ferner weist die Ladevorrichtung 1 mehrere parallel geschaltete Gleichrichtermodule 8 auf, über welche eine Wechselspannung des Wechselstromnetzes 4 in eine Gleichspannung gewandelt wird. Die Gleichspannung wird einem Gleichstrom-Ladeanschluss 11 der Ladevorrichtung 1 zugeführt. Über diesen Gleichstrom-Ladeanschluss 11 kann ein Hochvolt-Bordnetz eines Fahrzeugs an die Ladevorrichtung 1 angeschlossen werden, um einen elektrischen Energiespeicher des Hochvolt-Bordnetzes zu laden. Der Gleichstrom-Ladeanschluss 11 umfasst mindestens einen Pluspol und einen Minuspol.

Zwischen den Gleichrichtermodulen 8 und dem Ladeanschluss 11 ist ferner ein Ausgangsfilter 9 angeordnet, welches als EMV-Filter ausgestaltet ist. Zusätzlich befindet sich zwischen den Gleichrichtermodulen 8 und dem Ladeanschluss 11 eine Schaltvorrichtung 10, über welche die Gleichrichter 8 mit dem Gleichstrom-Ladeanschluss 11 verbunden werden können.

Um ein ungewolltes Auslösen der Fehlerstrom-Schutzeinrichtung zu verhindern sind bei der Ladevorrichtung 1 besondere Maßnahmen getroffen worden. Die Ladevorrichtung 1 weist eine Schutz- und Überwachungseinrichtung 7 auf, über welche ein Schutzleitwiderstand zwischen dem Neutralleiter und dem Schutzleiter erfasst werden kann. Zum Erfassen des Schutzleitwiderstands wird mittels der Schutz- und Überwachungseinrichtung ein Prüfstrom eingespeist, wobei eine Frequenz des Prüfstroms entweder außerhalb eines Kompensations-Frequenzbereichs der Schutz- und Überwachungseinrichtung liegt oder innerhalb des Kompensations-Frequenzbereichs liegt und schmalbandig aus dem Kompensations-Frequenzbereich herausgefiltert wird.

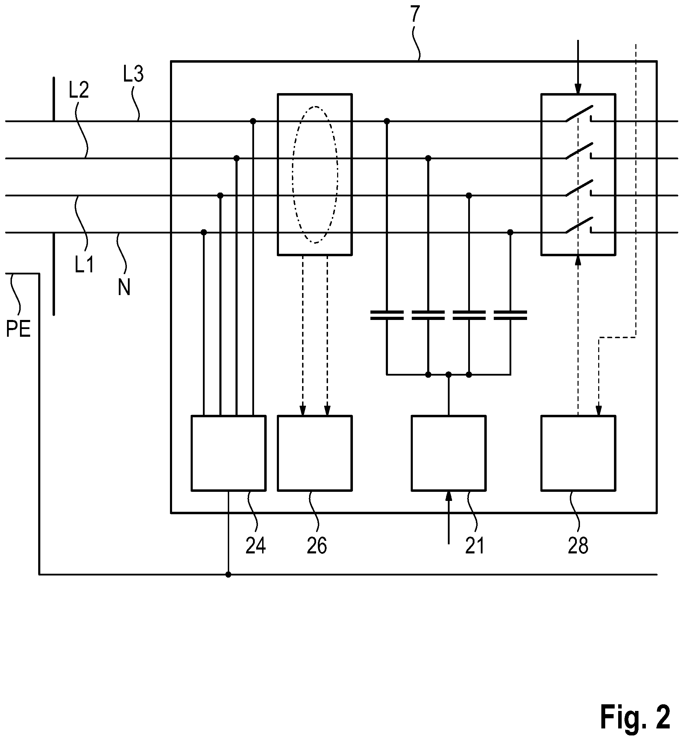

Einzelheiten der Schutz- und Überwachungseinrichtung 7 sollen nachfolgend anhand der Darstellung in Fig. 2 erläutert werden. Hierbei sind die Phasenleiter des Wechselstromnetzes 4 mit den Bezugszeichen L1, L2, L3 bezeichnet, der Neutralleiter mit N und der Schutzleiter mit PE.

Die Schutz- und Überwachungseinrichtung 7 umfasst einen Messstromwandler 26 der geeignet ist, einen im Schutzleiter PE auftretenden Ableitstrom zu erfassen. Der Messstromwandler 26 kann mit einer integrierten Signalauswertung versehen sein. Die Schutz- und Überwachungseinrichtung 7 umfasst ferner eine Schleifenwiderstandsmesseinrichtung 24, die zur Erfassung eines Fehlerstroms dient. In einer bevorzugten Ausgestaltung sind der Messstromwandler 26 und die Schleifenwiderstandsmesseinrichtung 24 in eine gemeinsame Messstromeinheit integriert.

Die Schutz- und Überwachungseinrichtung 7 umfasst ferner eine Stromkompensationseinheit 21, die in einem vorbestimmten Frequenzbereich zum Einspeisen eines zu dem Ableitstrom komplementären Kompensationsstroms geeignet ist.

Optional umfasst die Schutz- und Überwachungseinrichtung 7 eine Trennvorrichtung 28. Mittels der Trennvorrichtung 28 kann die elektrische Verbindung zwischen dem Wechselspannungsnetz 4 und den Gleichrichtermodule 8 getrennt werden.

Alternativ oder zusätzlich kann die Stromkompensationseinrichtung 21 dazu ausgebildet sein, einen Auslösestrom zum Auslösen einer in der Ladevorrichtung 1 installierten Schutzeinrichtung einzuspeisen. Dabei gleicht der Auslösestrom einem Differenzstrom, welcher normalerweise die Schutzeinrichtung auslöst. Dadurch lässt sich ein zusätzlicher Schutz im Falle von zum Beispiel verschweißten Relais-Kontakten erzielen.

Die in Fig. 1 gezeigte Ladevorrichtung 1 kann mittels eines Verfahrens gesteuert werden, welches die folgenden Verfahrensschritte umfasst:
- elektrisches Verbinden des Hochvolt-Bordnetzes mit dem Gleichstrom-Ladeanschluss 11 der Ladevorrichtung 1,
- Erfassen eines Schutzleitwiderstands zwischen dem Neutralleiter N und dem Schutzleiter SE durch Einspeisen eines Prüfstroms mittels der Schutz- und Überwachungseinrichtung 7, wobei eine Frequenz des Prüfstroms entweder außerhalb eines Kompensations-Frequenzbereichs der Schutz- und Überwachungseinrichtung 7 liegt oder innerhalb des Kompensations-Frequenzbereichs liegt und schmalbandig aus dem Kompensations-Frequenzbereich herausgefiltert wird.

Gemäß der Erfindung umfasst das Verfahren folgende weitere Verfahrensschritte:
- Erfassen eines Ableitstroms im Schutzleiter PE,
- in einem vorbestimmten Frequenzbereich, Einspeisen eines zu dem Ableitstrom komplementären Kompensationsstroms, vorzugsweise mittels einer Kapazität gekoppelten Stromkompensationseinheit 21.

In diesem Zusammenhang hat es sich als vorteilhaft erwiesen, wenn der Frequenzbereich zwischen 5 Hz und 300 kHz, vorzugsweise zwischen 25 Hz und 250 kHz, liegt.

Bevorzugt wird der Ableitstrom im Schutzleiter PE direkt oder indirekt mittels eines Messstromwandlers 26 erfasst.

Bevorzugt erfolgt das Einspeisen des Kompensationsstroms in Echtzeit oder Quasi-Echtzeit. Unter einem Einspeisen des Kompensationsstroms in Echtzeit oder Quasi-Echtzeit wird verstanden, dass das Einspeisen des Kompensationsstroms innerhalb derselben Netzperiode erfolgt, in welcher der Ableitstrom in dem Schutzleiter PE erfasst wird.

Vorzugsweise umfasst das Verfahren folgenden weiteren Verfahrensschritt: Trennung der elektrischen Verbindung zwischen dem Gleichstrom-Ladeanschluss 11 und dem Wechselstromnetz, entweder durch Auslösen der Trennvorrichtung 28 der Schutz- und Überwachungseinrichtung 7 oder durch Einspeisen eines einem Differenzstrom gleichenden Auslösestroms zum Auslösen einer in der Ladevorrichtung 1 installierten Schutzeinrichtung.

Die beschriebene Schutz- und Überwachungseinrichtung 7 dient insbesondere dazu, den auftretenden Ableitstrom aus in dem Hochvolt-Bordnetz des Fahrzeugs installierten Y-Kapazitäten innerhalb der Ladeeinrichtung 1 zu kompensieren.

Die Kompensationseinheit 21 ist ausgebildet, eine gleichbleibende Kompensation in einem gegebenen Frequenzbereich zu erzielen, und nicht ausschließlich, wie bei den aus dem Stand der Technik bekannten Kompensationseinheiten, in den Frequenzen spezifischer Netzharmonien.

Mittels der Schutz- und Überwachungseinrichtung 7 können in dem Hochvolt-Bordnetz auftretende Ableitströme, beispielsweise durch Hbchvoltkomponenten, beispielsweise einen Klimakompressor, kompensiert werden.

## Patentansprüche

1. Verfahren zur Steuerung einer fahrzeugexternen Ladevorrichtung (1) zum Laden eines Fahrzeugs, insbesondere eines Elektro- oder Hybridfahrzeugs, wobei die Ladevorrichtung (1) ein Wechselstromnetz (4) mit einem Neutralleiter (N), einem Schutzleiter (PE) und wenigstens einem Phasenleiter (L1, L2, L3), eine Schutz- und Überwachungseinrichtung (7) sowie einen Gleichstrom-Ladeanschluss (11) aufweist, wobei das Fahrzeug ein Hochvolt-Bordnetz und einen an das Hochvolt-Bordnetz angeschlossenen elektrischen Energiespeicher umfasst, wobei das Verfahren folgende Verfahrensschritte umfasst:
- elektrisches Verbinden des Hochvolt-Bordnetzes, mit dem Gleichstrom-Ladeanschluss (11) der Ladevorrichtung (1),
- Erfassen eines Ableitstroms im Schutzleiter (PE),
**gekennzeichnet dadurch , dass** es weiterhin die folgenden Schritte umfasst:
- in einem vorbestimmten Frequenzbereich, Einspeisen eines zu dem Ableitstrom komplementären Kompensationsstroms, vorzugsweise mittels einer kapazitiv gekoppelten Stromkompensationseinheit (21),
- Erfassen eines Schutzleitwiderstands zwischen dem Neutralleiter (N) und dem Schutzleiter (PE) durch Einspeisen eines Prüfströms mittels der Schutz- und Überwachungseinrichtung (7), wobei eine Frequenz des Prüfstroms entweder außerhalb eines Kompensations-Frequenzbereichs der Schutz- und Überwachungseinrichtung liegt oder innerhalb des Kompensations-Frequenzbereichs liegt und schmalbandig aus dem Kompensations-Frequenzbereich herausgefiltert wird.

2. Verfahren nach Anspruch 1, **dadurch gekennzeichnet, dass** der Frequenzbereich zwischen 5 Hz und 300 kHz, vorzugsweise zwischen 25 Hz und 250 kHz, liegt.

3. Verfahren nach einem der Ansprüche 1 oder 2, **dadurch gekennzeichnet, dass** der Ableitstrom im Schutzleiter (PE) direkt oder indirekt mittels eines Messstromwandlers (26) erfasst wird.

4. Verfahren nach einem der Ansprüche 2 bis 3, **dadurch gekennzeichnet, dass** das Einspeisen des Kompensationsstroms in Echtzeit oder Quasi-Echtzeit erfolgt.

5. Verfahren nach einem der vorhergehenden Ansprüche, **gekennzeichnet durch** folgenden weiteren Verfahrensschritt:
Trennung der elektrischen Verbindung zwischen dem Gleichstrom-Ladeanschluss (11) und dem Wechselstromnetz (4), entweder **durch** Auslösen einer Trennvorrichtung (28) der Schutz- und Überwachungseinrichtung (7) oder **durch** Einspeisen eines einem Differenzstrom geleichenden Auslösestroms zum Auslösen einer in der Ladevorrichtung (1) installierten Schutzeinrichtung.

6. Ladevorrichtung (1) zum Laden eines Fahrzeugs, insbesondere eines Elektro- oder Hybridfahrzeugs, die ein Wechselstromnetz (4) mit einem Neutralleiter (N), einem Schutzleiter (PE) und wenigstens einem Phasenleiter (L1, L2, L3), eine Schutz- und Überwachungseinrichtung (7) sowie einen Gleichstrom-Ladeanschluss (11) aufweist, der zur Verbindung mit einem Hochvolt-Bordnetz eines Fahrzeugs geeignet ist, wobei die Ladevorrichtung (1) durch ein Verfahren nach einem der vorhergehenden Ansprüche steuerbar ist, wobei die Schutz- und Überwachungseinrichtung (7) einen Messstromwandler (26) aufweist, der geeignet ist, Ableitstrom im Schutzleiter (PE) direkt oder indirekt zu erfassen und wobei die Schutz-und Überwachungseinrichtung (7) eine Schleifenwiderstandsmesseinrichtung (24) aufweist, die geeignet ist, einen Schutzleitwiderstand zwischen dem Neutralleiter (N) und dem Schutzleiter (SE) zu erfassen.

7. Ladevorrichtung nach Anspruch 6, **dadurch gekennzeichnet, dass** der Messstromwandler (26) und die Schleifenwiderstandsmesseinrichtung (24) in eine Messstromeinheit integriert sind.

8. Ladevorrichtung nach einem der Ansprüche 6 oder 7, **gekennzeichnet durch** mehrere parallel geschaltete Gleichrichtermodule (8).

## Claims

1. Method for controlling a vehicle-external charging device (1) for charging a vehicle, in particular an electric or hybrid vehicle, wherein the charging device (1) has an AC current grid (4) having a neutral conductor (N), a protective conductor (PE) and at least one phase conductor (L1, L2, L3), a protection and monitoring apparatus (7), and a DC current charging terminal (11), wherein the vehicle comprises a high-voltage on-board power system and an electrical energy store connected to the high-voltage on-board power system, wherein the method comprises the following method steps:
- electrically connecting the high-voltage on-board power system to the DC current charging terminal (11) of the charging device (1),
- detecting a stray current in the protective conductor (PE),
**characterized in that** said method furthermore comprises the following steps:
- feeding in a compensation current, which is complementary to the stray current, in a predetermined frequency range, preferably by way of a capacitively coupled current compensation unit (21),
- detecting a protective conductor resistance between the neutral conductor (N) and the protective conductor (PE) by feeding in a test current by way of the protection and monitoring apparatus (7), wherein a frequency of the test current is either outside of a compensation frequency range of the protection and monitoring apparatus or is within the compensation frequency range and is filtered out of the compensation frequency range on a narrowband basis.

2. Method according to Claim 1, **characterized in that** the frequency range is between 5 Hz and 300 kHz, preferably between 25 Hz and 250 kHz.

3. Method according to either of Claims 1 and 2, **characterized in that** the stray current is detected directly or indirectly in the protective conductor (PE) by way of a measurement current transducer (26).

4. Method according to one of Claims 2 to 3, **characterized in that** the compensation current is fed in in real time or quasi-real time.

5. Method according to one of the preceding claims, **characterized by** the following further method step:
disconnecting the electrical connection between the DC current charging terminal (11) and the AC current grid (4), either by tripping a disconnection device (28) of the protection and monitoring apparatus (7) or by feeding in a trip current equal to a differential current in order to trip a protection apparatus installed in the charging device (1).

6. Charging device (1) for charging a vehicle, in particular an electric or hybrid vehicle, which charging device has an AC current grid (4) having a neutral conductor (N), a protective conductor (PE) and at least one phase conductor (L1, L2, L3), a protection and monitoring apparatus (7), and a DC current charging terminal (11) that is suitable for connection to a high-voltage on-board power system of a vehicle, wherein the charging device (1) is able to be controlled by a method according to one of the preceding claims, wherein the protection and monitoring apparatus (7) has a measurement current transducer (26) that is suitable for directly or indirectly detecting stray current in the protective conductor (PE) and wherein the protection and monitoring apparatus (7) has a loop resistance measurement apparatus (24) that is suitable for detecting a protective conductor resistance between the neutral conductor (N) and the protective conductor (SE).

7. Charging device according to Claim 6, **characterized in that** the measurement current transducer (26) and the loop resistance measurement apparatus (24) are integrated into a measurement current unit.

8. Charging device according to either of Claims 6 and 7, **characterized by** a plurality of rectifier modules (8) connected in parallel.

## Revendications

1. Procédé de commande d'un arrangement de charge (1) externe au véhicule pour la charge d'un véhicule, notamment d'un véhicule électrique ou hybride, l'arrangement de charge (1) possédant un réseau à courant alternatif (4) doté d'un conducteur neutre (N), d'un conducteur de terre (PE) et d'au moins un conducteur de phase (L1, L2, L3), un dispositif de protection et de surveillance (7) ainsi qu'une borne de charge à courant continu (11), le véhicule comportant un réseau de bord à haute tension et un accumulateur d'énergie électrique raccordé au réseau de bord à haute tension, le procédé comprenant les étapes suivantes :
- connexion électrique du réseau de bord à haute tension à la borne de charge à courant continu (11) de l'arrangement de charge (1),
- détection d'un courant de fuite dans le conducteur de terre (PE),
**caractérisé en ce qu'**il comprend en outre les étapes suivantes :
- dans une plage de fréquences prédéterminée, injection d'un courant complémentaire au courant de fuite, de préférence au moyen d'une unité de compensation de courant (21) couplée de manière capacitive,
- détection d'une résistance de conducteur de terre entre le conducteur neutre (N) et le conducteur de terre (PE) en injectant un courant d'essai au moyen du dispositif de protection et de surveillance (7), une fréquence du courant d'essai se trouvant soit en dehors de la plage de fréquences de compensation du dispositif de protection et de surveillance, soit à l'intérieur de la plage de fréquences de compensation et étant éliminé de la plage de fréquences de compensation par filtrage à bande étroite.

2. Procédé selon la revendication 1, **caractérisé en ce que** la plage de fréquences est comprise entre 5 Hz et 300 kHz, de préférence entre 25 Hz et 250 kHz.

3. Procédé selon l'une des revendications 1 et 2, **caractérisé en ce que** le courant de fuite dans le conducteur de terre (PE) est détecté directement ou indirectement au moyen d'un convertisseur de courant de mesure (26).

4. Procédé selon l'une des revendications 2 à 3, **caractérisé en ce que** l'injection du courant de compensation s'effectue en temps réel ou en temps quasiréel.

5. Procédé selon l'une des revendications précédentes, **caractérisé par** l'étape supplémentaire suivante :
sectionnement de la connexion électrique entre la borne de charge à courant continu (11) du réseau à courant alternatif (4), soit par déclenchement d'un arrangement de sectionnement (28) du dispositif de protection et de surveillance (7), soit par injection d'un courant de déclenchement égal à un courant différentiel afin de déclencher un dispositif de protection installé dans l'arrangement de charge (1).

6. Arrangement de charge (1) destiné à charger un véhicule, notamment un véhicule électrique ou hybride, qui possède un réseau à courant alternatif (4) doté d'un conducteur neutre (N), d'un conducteur de terre (PE) et d'au moins un conducteur de phase (L1, L2, L3), un dispositif de protection et de surveillance (7) ainsi qu'une borne de charge à courant continu (11), laquelle est adaptée pour être connectée à un réseau de bord à haute tension d'un véhicule, l'arrangement de charge (1) pouvant être commandé par un procédé selon l'une des revendications précédentes, le dispositif de protection et de surveillance (7) possédant un convertisseur de courant de mesure (26) qui est adapté pour détecter directement ou indirectement un courant de fuite dans le conducteur de terre (PE), et le dispositif de protection et de surveillance (7) possédant un dispositif de mesure de résistance de boucle (24) qui est adapté pour détecter une résistance de conducteur de terre entre le conducteur neutre (N) et le conducteur de terre (SE).

7. Arrangement de charge selon la revendication 6, **caractérisé en ce que** le convertisseur de courant de mesure (26) et le dispositif de mesure de résistance de boucle (24) sont intégrés dans une unité de courant de mesure.

8. Arrangement de charge selon l'une des revendications 6 ou 7, **caractérisé par** plusieurs modules redresseurs (8) branchés en parallèle.
